# EUROPEAN PATENT APPLICATION

(11) **EP 1 571 643 A1**
(43) Date of publication of application: **07.09.2005**
(21) Application number: 03774043.8
(22) Date of filing: 19.11.2003
(51) Int. Cl.: G09G 3/30, G09G 3/20, G09F 9/30, H05B 33/14

(54) **ORGANIC EL DISPLAY AND ACTIVE MATRIX SUBSTRATE**

(30) Priority: 20.11.2002 JP 2002336920
(71) Applicant: Toshiba Matsushita Display Technology Co., Ltd., Tokyo 108-0075 (JP)
(72) Inventor: SHIBUSAWA, Makoto, Fukaya-shi, Saitama 366-0051 (JP)
(74) Representative: HOFFMANN EITLE
(86) International application number: PCT/JP2003/014705
(87) International publication number: WO 2004/047064

(57) **Abstract**

There is provided an active matrix organic EL display (1) including a drive control element (30) which includes a first terminal connected to a power supply terminal (31), a control terminal, and a second terminal, an organic EL element (20) connected between the second terminal and a power supply terminal (34), a capacitor (38) connected to the control terminal, a first switch (37) which executes switching in accordance with a scan signal to set the video signal input terminal (35) and the second terminal in a connected state during a signal write period and set them in a disconnected state during a light emission period, and a second switch (32) which executes switching to set the control terminal and the second terminal in the connected state during the signal write period and set them in the disconnected state before the first switch (37) changes to the disconnected state.

## Description

### Technical Field

The present invention relates to an active matrix display and active matrix substrate and, more particularly, to an active matrix organic EL (ElectroLuminescent) display including organic EL elements serving as display elements and an active matrix substrate usable in the organic EL display.

### Background Art

Flat panel displays represented by liquid crystal displays have, as their characteristic features, a low profile, light weight, and low power consumption as compared to CRT displays. Demand for flat panel displays is growing sharply due to these characteristic features.

In an active matrix flat panel display, each pixel has a switch which can electrically disconnect an ON pixel from an OFF pixel. Normally, the pixel also has a capacitor which holds a video signal. This display, therefore, can realize a satisfactory display quality without crosstalk between adjacent pixels. For this reason, active matrix flat panel displays are used in various kinds of electronic devices including portable information terminals.

In recent years, organic EL displays have actively been developed. Organic EL displays are self-emission displays and are more advantageous in realizing high-speed response and wide viewing angle than liquid crystal displays.

Knapp et al have disclosed a pixel circuit usable in an organic EL display in U.S. Patent No. 6,373,454B1.

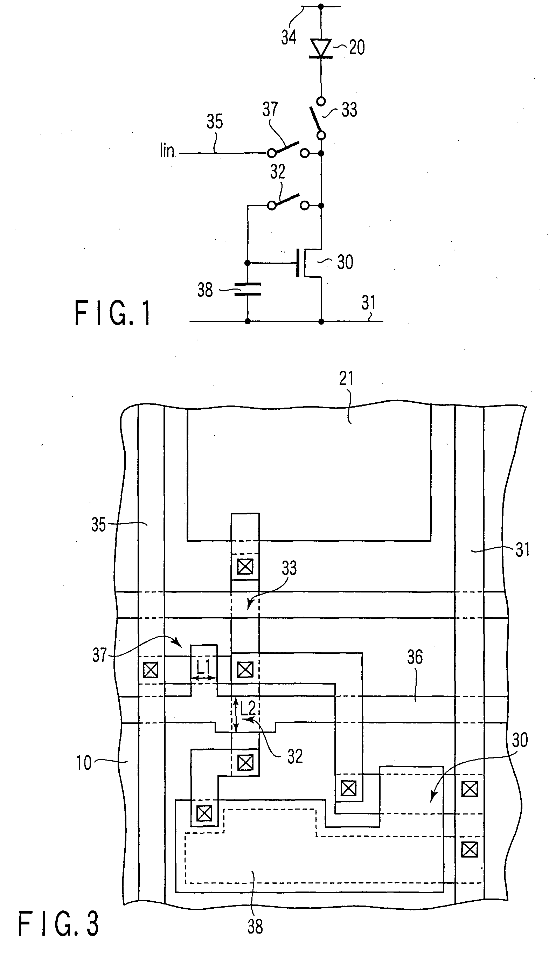

FIG. 1 is an equivalent circuit diagram of the pixel circuit disclosed by Knapp et al. The operation of this circuit is performed in two stages. At the first and second stages, a power supply line 31 is set to a potential V1, and a power supply line 34 is set to a potential V2 higher than the potential V1.

At the first stage, a switch 33 is opened (OFF), and switches 32 and 37 are closed (ON). In this state, a signal current is supplied from a video signal wiring line 35 to an organic EL element 20 as an input signal. A transistor 30 is diode-connected by the switch 32. For this reason, a voltage equal to the gate-to-source voltage of the transistor 30, through which the signal current flows, is stored in a capacitor 38. Then, the switches 32 and 37 are opened.

At the second stage, the switch 33 is closed to connect the organic EL element 20 to the drain of the transistor 30. Since a voltage corresponding to the input signal is stored in the capacitor 38, a current almost equal to the input signal is supplied to the organic EL element 20.

In this pixel circuit, the switching operations, i.e., the ON/OFF operations of the switches 32 and 37 are executed simultaneously. Hence, the switching of the switches 32 and 37 can be controlled by using the same control line.

However, even when these switches are controlled by using the same control line, the switching operations of the switches 32 and 37 are not always executed simultaneously because of characteristic variations caused by the design or process of the pixel circuit pattern.

When the OFF operation of the switch 32 is done later than that of the switch 37, a current flows from the gate of the transistor 30 to the power supply line 31 through the switch 32 and transistor 30 during the period between the OFF operation of the switch 37 and that of the switch 32. As a result, the gate-to-source voltage of the transistor 30 decreases. In this case, the grayscale range may be diminished. Especially when the time lag between the OFF operations varies between pixels, in-plane nonuniformity of luminance may also occur.

This problem can be solved by separately preparing a control line for the switch 32 and that for the switch 37 and supplying an OFF signal to the former earlier than the latter. In this case, however, a control line is added to each column of pixels. This makes restrictions on pixel layout stricter and decreases the area in which the individual organic EL elements can be laid out. When bright display is done by small organic EL elements, the luminance service life shortens.

### Disclosure of Invention

An object of the present invention is to provide an active matrix organic EL display capable of realizing an excellent display quality by using a relatively small number of wiring lines and an active matrix substrate usable in the organic EL display.

According to a first aspect of the present invention, there is provided an active matrix organic EL display comprising a drive control element comprising a first terminal connected to a first power supply terminal, a control terminal to which a video signal is supplied from a video signal input terminal, and a second terminal which outputs a driving current having a magnitude corresponding to a voltage between the control terminal and the first terminal, an organic EL element connected between the second terminal and a second power supply terminal, a capacitor which has one electrode connected to the control terminal and can maintain the voltage between the control terminal and the first terminal at a magnitude corresponding to the video signal, a first switch which executes switching in accordance with a scan signal to set the video signal input terminal and the second terminal in a connected state during a signal write period and set the video signal input terminal and the second terminal in a disconnected state during a light emission period next to the signal write period, and a second switch which executes switching in accordance with the scan signal to set the control terminal and the second terminal in the connected state during the signal write period and set the control terminal and the second terminal in the disconnected state before the first switch changes to the disconnected state.

According to a second aspect of the present invention, there is provided an active matrix organic EL display comprising a drive control element which comprising a first terminal connected to a first power supply terminal, a control terminal, and a second terminal which outputs a driving current having a magnitude corresponding to a voltage between the control terminal and the first terminal, an organic EL element connected between the second terminal and a second power supply terminal, a capacitor connected between a constant potential terminal and the control terminal, a first switch connected between a video signal input terminal and the second terminal, and a second switch connected between the control terminal and the second terminal, wherein a control terminal which controls switching of the first switch is connected to a control terminal which controls switching of the second switch, and a threshold value of the first switch is shallower than a threshold value of the second switch.

According to a third aspect of the present invention, there is provided an active matrix organic EL display comprising a drive control element comprising a first terminal connected to a first power supply terminal, a control terminal, and a second terminal which outputs a driving current having a magnitude corresponding to a voltage between the control terminal and the first terminal, an organic EL element connected between the second terminal and a second power supply terminal, a capacitor connected between a constant potential terminal and the control terminal, a delay element comprising an input terminal connected to a control signal input terminal and an output terminal which outputs a control signal supplied from the control signal input terminal, a first switch connected between a video signal input terminal and the second terminal, and a second switch connected between the control terminal and the second terminal, wherein a control terminal which controls switching of the first switch is connected to the output terminal, and a control terminal which controls switching of the second switch is connected to the control signal input terminal.

According to a fourth aspect of the present invention, there is provided an active matrix substrate on which an organic EL element is to be formed, comprising a drive control element comprising a first terminal connected to a power supply terminal, a control terminal to which a video signal is supplied from a video signal input terminal, and a second terminal which is connected to the organic EL element and outputs a driving current having a magnitude corresponding to a voltage between the control terminal and the first terminal, a capacitor which has one electrode connected to the control terminal and can maintain the voltage between the control terminal and the first terminal at a magnitude corresponding to the video signal, a first switch which executes switching in accordance with a scan signal to set the video signal input terminal and the second terminal in a connected state during a signal write period and set the video signal input terminal and the second terminal in a disconnected state during a light emission period next to the signal write period, and a second switch which executes switching in accordance with the scan signal to set the control terminal and the second terminal in the connected state during the signal write period and set the control terminal and the second terminal in the disconnected state before the first switch changes to the disconnected state.

According to a fifth aspect of the present invention, there is provided an active matrix substrate comprising a pixel electrode, a drive control element comprising a first terminal connected to a power supply terminal, a control terminal to which a video signal is supplied from a video signal input terminal, and a second terminal which is connected to the pixel electrode and outputs a driving current having a magnitude corresponding to a voltage between the control terminal and the first terminal, a capacitor which has one electrode connected to the control terminal and can maintain the voltage between the control terminal and the first terminal at a magnitude corresponding to the video signal, a first switch which executes switching in accordance with a scan signal to set the video signal input terminal and the second terminal in a connected state during a signal write period and set the video signal input terminal and the second terminal in a disconnected state during a light emission period next to the signal write period, and a second switch which executes switching in accordance with the scan signal to set the control terminal and the second terminal in the connected state during the signal write period and set the control terminal and the second terminal in the disconnected state before the first switch changes to the disconnected state.

### Brief Description of Drawings

FIG. 1 is an equivalent circuit diagram of a conventional pixel circuit;
FIG. 2 is a plan view schematically showing an organic EL display according to the first embodiment of the present invention;
FIG. 3 is a plan view schematically showing an example of a structure which can be employed in a pixel of the organic EL display shown in FIG. 2;
FIG. 4 is a timing chart showing an example of the driving method of the organic EL display shown in FIG. 2;
FIG. 5 is a plan view schematically showing a modification of the pixel structure shown in FIG. 3;
FIG. 6 is a sectional view schematically showing an example of a structure which can be employed in the first switch;
FIG. 7 is a sectional view schematically showing an example of a structure which can be employed in the second switch;
FIG. 8 is a plan view schematically showing an organic EL display according to the second embodiment of the present invention;
FIG. 9 is a view showing an example of the waveforms of a signal input to the delay element and a signal output from the delay element;
FIG. 10 is an equivalent circuit diagram showing an example of a pixel circuit which can be employed in the organic EL display shown in FIG. 8;
FIG. 11 is an equivalent circuit diagram showing another example of the pixel circuit which can be employed in the organic EL display shown in FIG. 8; and
FIG. 12 is an equivalent circuit diagram showing still another example of the pixel circuit which can be employed in the organic EL display shown in FIG. 8.

### Best Mode for Carrying Out the Invention

The embodiments of the present invention will be described with reference to the accompanying drawings. In the following embodiments, as an example, the present invention is applied to an organic EL display.

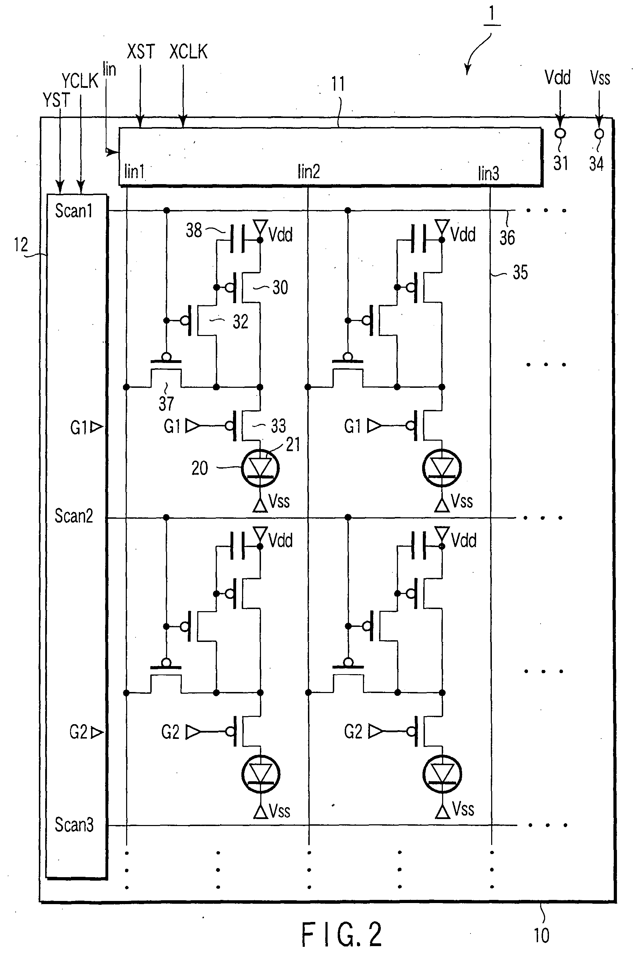

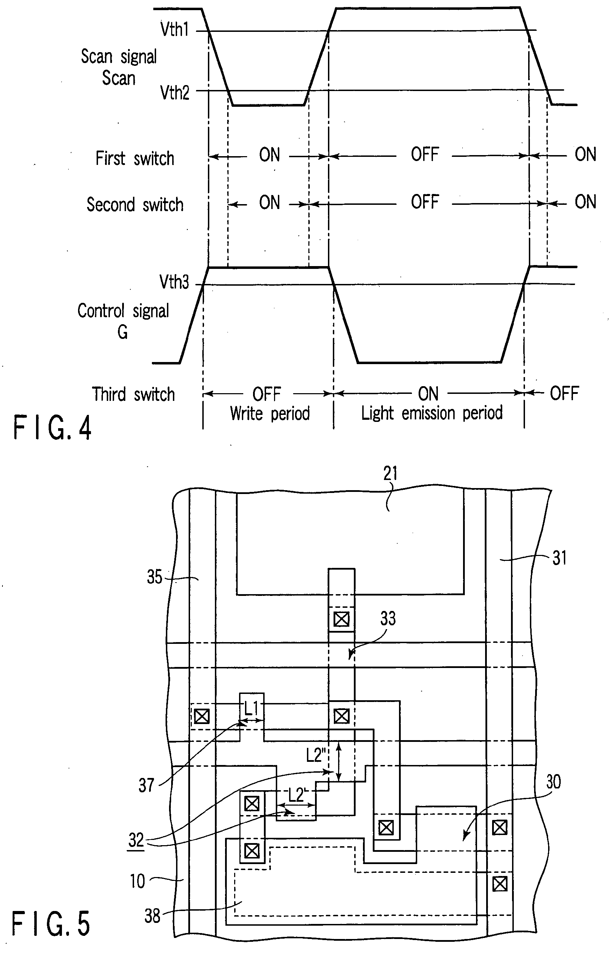

FIG. 2 is a plan view schematically showing an organic EL display according to the first embodiment of the present invention. FIG. 3 is a plan view schematically showing an example of a structure which can be employed in a pixel of the organic EL display shown in FIG. 2.

An organic EL display 1 includes an insulating substrate 10 made of, e.g., glass. A plurality of pixels arrayed in a matrix and a driving circuit which drives the pixels are arranged on the substrate 10.

The driving circuit includes a video signal line driver 11, a scan signal line driver 12, video signal lines 35 connected to the video signal line driver 11, control lines 36 serving as scan signal lines connected to the scan signal line driver 12, a first power supply line 31, and a second power supply line 34. This driving circuit drives the pixel circuits on the basis of control signals YST, YCLK, XST, and XCLK, power supply potentials Vdd and Vss, and a data signal Iin, which are supplied externally.

Each pixel includes a display element 20 and a pixel circuit which drives the display element 20. The pixel circuit and display element 20 are connected in series between the first power supply terminal set to the potential Vdd and the second power supply terminal set to the potential Vss. The first and second power supply terminals are connected to the first power supply line 31 and second power supply line 34, respectively. The potential Vdd is set to be higher than the potential Vss.

The display element 20 includes a pair of electrodes facing each other and an active layer inserted between them. The "active layer" here is a layer whose optical characteristic such as luminance or transmittance changes in accordance with the voltage applied between the electrodes. In this example, the display element 20 is an organic EL element and has, as an active layer, an organic layer including an organic light-emitting layer.

The pixel circuit includes a drive control element 30, capacitor 38, first switch 37, second switch 32, and third switch 33. As the drive control element 30 and switches 37, 32, and 33, for example, field effect transistors of first conduction type can be used. In this example, p-channel thin-film transistors are used as the drive control element 30 and switches 37, 32, and 33.

The first terminal, i.e., the source of the drive control element 30 is connected to the first power supply terminal set to the potential Vdd. One electrode of the capacitor 38 is connected to the control terminal, i.e., the gate of the drive control element 30. Hence, the capacitor 38 holds the potential difference between the first terminal and control terminal of the drive control element 30, which corresponds to a video signal. In this example, the capacitor 38 is connected between the first power supply terminal and the control terminal of the drive control element 30. The first switch 37 is connected between the video signal input terminal and the second terminal, i.e., the drain of the drive control element 30. The video signal input terminal is connected to the video signal line 35. The second switch 32 is connected in the gate-to-drain path of the drive control element 30. The control terminals, i.e., the gates of the first switch 37 and second switch 32 are connected to the control line 36 serving as a scan signal line. The third switch 33 is connected between the drain of the drive control element 30 and a first electrode 21 of the display element 20.

In this example, the first electrode 21 is an anode. The second electrode of the display element 20 is a cathode connected to the second power supply terminal set to the potential Vss. In this example, the first power supply terminal is used as a constant potential terminal to which the capacitor 38 should be connected. The capacitor 38 may be connected between another constant potential terminal and the control terminal of the drive control element 30.

In the organic EL display 1, the input terminals, i.e., the sources of the switches 37 included in each pixel column are connected to one video signal line 35 which is common to that column. A signal current is supplied from the video signal line driver 11 to the video signal line 35 as an input signal or video signal Iin.

The control terminals, i.e., the gates of the switches 37 and 32 included in each pixel row are connected to one scan signal line 36 which is common to that row. A voltage signal is sequentially supplied from the scan signal line driver 12 to the scan signal line 36 as a scan signal Scan.

A structure obtained by removing at least one electrode and active layer of each display element 20 from the organic EL display 1 corresponds to an active matrix substrate. The active matrix substrate includes the insulating substrate 10, the wiring lines such as the video signal lines 35, scan signal lines 36, and power supply lines, and the pixel circuits. The active matrix substrate can arbitrarily include the video signal line driver 11, scan signal line driver 12, and the first electrodes 21 of the display elements 20.

In the organic EL display 1, the first switch 37 and second switch 32 can have identical layered structure and can simultaneously be formed. The first switch 37 and second switch 32 are, e.g., thin-film transistors which have a top-gate structure using polysilicon as a semiconductor layer and are formed simultaneously. In this embodiment, the first switch 37 and second switch 32 are designed such that they have identical structures except that a channel length L1 of the first switch 37 is shorter than a channel length L2 of the second switch 32. Accordingly, the first switch 37 having a shallower threshold value Vth1 and the second switch 32 having a deeper threshold value Vth2 are obtained.

As the first switch 37 and second switch 32, for example, thin-film transistors having a top-gate structure (coplanar structure) using polysilicon as a semiconductor layer are used. The first switch 37 and second switch 32 employ the same layered structure and are formed simultaneously. The channel widths of the first switch 37 and second switch 32 are set to, e.g., 3 µm. The channel lengths of the first switch 37 and second switch 32 are set to, e.g., 3 µm and 4.5 µm, respectively. Accordingly, the first switch 37 having the shallower threshold value Vth1 and the second switch 32 having the deeper threshold value Vth2 can be obtained.

In each pixel circuit, the gates of the first switch 37 and second switch 32 are connected to the same scan signal line 36. For this reason, the same control signal is simultaneously supplied to the gates of the first switch 37 and second switch 32.

When the same OFF signal is simultaneously supplied to the gates of the first switch 37 and second switch 32, the second switch 32 having the deeper threshold value Vth2 starts the OFF operation earlier than the first switch 37 having the shallower threshold value Vth1. That is, in the organic EL display 1, the second switch 32 can be set in the disconnected state before the first switch 37 is set in the disconnected state.

For this reason, the second switch 32 can be prevented from executing the OFF operation earlier than the first switch 37, and accordingly, any variation in gate-to-source voltage of the drive control element 30 can be prevented. Since any degradation in grayscale performance, or in-plane nonuniformity of luminance can be suppressed, an excellent display quality can be implemented by using a relatively small number of wiring lines.

The channel lengths of the first switch 37 and second switch 32 can appropriately be set within the range of not harming the layout of the remaining transistors, capacitor, and wiring lines included in the pixel circuit.

The third switch 33 and drive control element 30 can be designed to have almost the same structure as the first switch 37 and second switch 32. For example, as the drive control element 30 and first to third switches 37, 32, and 33, thin-film transistors of first conduction type may be used. They may simultaneously be formed. In this case, the pixel circuit can be formed by a relatively small number of steps.

The operation of the organic EL display 1 will be described next in more detail.

FIG. 4 is a timing chart showing an example of the driving method of the organic EL display shown in FIG. 2.

The scan signal line driver 12 sequentially outputs, to the scan signal lines 36, the scan signal Scan which sets the first switch 37 and second switch 32 in a conductive state. The leading and trailing edges of the scan signal Scan are moderate because of the wiring resistance and capacitance. For example, as shown in FIG. 4, the potential waveform of the scan signal Scan is obtuse in correspondence with a time constant.

The scan signal line driver 12 also sequentially outputs, to the rows of the third switches 33, a control signal G which sets the third switches 33 in the conductive state. The light emission period corresponds to a period in which the third switch 33 is in the conductive state. In this example, the video signal write is executed for each row. A period in which the write is executed for a certain row corresponds to the light emission period of another row. Normally, during the signal write period, the third switch 33 is set in a non-conductive state to electrically disconnect the display element 20 from the pixel circuit.

During the write period, the scan signal Scan which sets the first switch 37 and second switch 32 in the conductive state is supplied to the scan signal line 36. Accordingly, the first switch 37 having the shallower threshold value Vth1 is set first in the conductive state. Next, the second switch 32 having the deeper threshold value Vth2 is set in the conductive state. At this time, the input signal Iin is supplied from the video signal line driver 11 to the pixel circuit through the video signal line 35. More specifically, a driving current corresponding to the input signal Iin is supplied to the drive control element. Accordingly, the gate potential of the drive control element 30 is set to a value corresponding to the input signal Iin.

After that, the scan signal Scan supplied from the scan signal line driver 12 to the scan signal line 36 changes from the ON signal which sets the first switch 37 and second switch 32 in the conductive state to an OFF signal which sets them in a non-conductive state. Accordingly, the second switch 32 having the deeper threshold value Vth2 is set first in the non-conductive state. Next, the first switch 37 having the shallower threshold value Vth1 is set in the non-conductive state. For this reason, any charge leakage from the capacitor 38 is prevented. The gate potential of the drive control element 30 is maintained at the value corresponding to the input signal Iin.

During the light emission period, the third switch 33 is set in the conductive state by the control signal G supplied to it. Since the gate potential of the drive control element 30 is maintained at the value corresponding to the input signal Iin, a current almost equal to the input signal Iin flows to the organic EL element 20. More specifically, the organic EL element 20 emits light at a luminance corresponding to the input signal Iin.

As described above, in this embodiment, the channel length L2 of the second switch 32 is set to be longer than the channel length L1 of the first switch 37. Then, the threshold value Vth2 of the second switch 32 is deeper than the threshold value Vth1 of the first switch 37. Consequently, when the same OFF signal is supplied to the gates of the first switch 37 and the second switch 32, the second switch 32 can be set in the non-conductive state earlier than the first switch 37. Hence, according to this embodiment, the organic EL display 1 which suppresses any degradation in grayscale performance or in-plane nonuniformity of luminance can be implemented.

In the above-described embodiment, each of the first switch 37 and second switch 32 has one channel between the source and drain. However, these switches may have another structure. For example, the first switch 37 and second switch 32 may employ a multi-gate structure having a plurality of channels between the source and drain. In this case, when the total channel length L2 (= L2' + L2" + ...) of the second switch 32 is longer than the total channel length L1 (= L1' + L1" + ...) of the first switch 37, the same effect as described above can be obtained.

FIG. 5 is a plan view schematically showing a modification of the pixel structure shown in FIG. 3. The multi-gate structure can be employed in one or both of the first switch 37 and second switch 32. To suppress the influence of the OFF current on the display operation, the multi-gate structure is preferably employed in the second switch 32, as shown in FIG. 5.

The difference in threshold value between the first switch 37 and the second switch 32 is preferably about 0.2V to 1V. In this case, the second switch 32 can more reliably be set in the non-conductive state earlier than the first switch 37.

In the above-described embodiment, the threshold value is changed between the first switch 37 and the second switch 32 by using the channel length. The threshold value can also be changed by another method. For example, the threshold value may be changed between the first switch 37 and the second switch 32 by using the number of channels. More specifically, when the number of channels of the second switch 32 is larger than that of the first switch 37, the threshold value of the second switch 32 becomes deeper than that of the first switch 37, even if they have the same total channel length.

Alternatively, the impurity dose may be changed between the first switch 37 and the second switch 32. For example, assume that p-channel thin-film transistors are used as the first switch 37 and second switch 32. In this case, when the dose of the p-type dopant in the channel of the first switch 37 is larger than that in the channel of the second switch 32, the threshold value of the second switch 32 becomes deeper than that of the first switch 37.

The first switch 37 and second switch 32 with different impurity doses can be formed by, e.g., the following method. In a normal process for forming a thin-film transistor, the number of times of impurity doping in the channel region of the first switch 37 is made larger than that in the channel region of the second switch 32. For example, first, an impurity is doped into the channel regions of the first switch 37 and second switch 32. Next, the channel region of the second switch 32 is masked by using a photoresist. Subsequently, the impurity is doped in the channel region of the first switch 37 again. Accordingly, the dose of the dopant in the channel of the first switch 37 is larger than that of the p-type dopant in the channel of the second switch 32.

If the threshold value should be changed between the first switch 37 and the second switch 32 by using the impurity dose, the dose difference between the switches is preferably about 1 × 10¹¹ cm⁻² to 5 × 10¹¹ cm⁻². In this case, the second switch 32 can more reliably be set in the non-conductive state earlier than the first switch 37.

The threshold value can be changed between the first switch 37 and the second switch 32 by still another method.

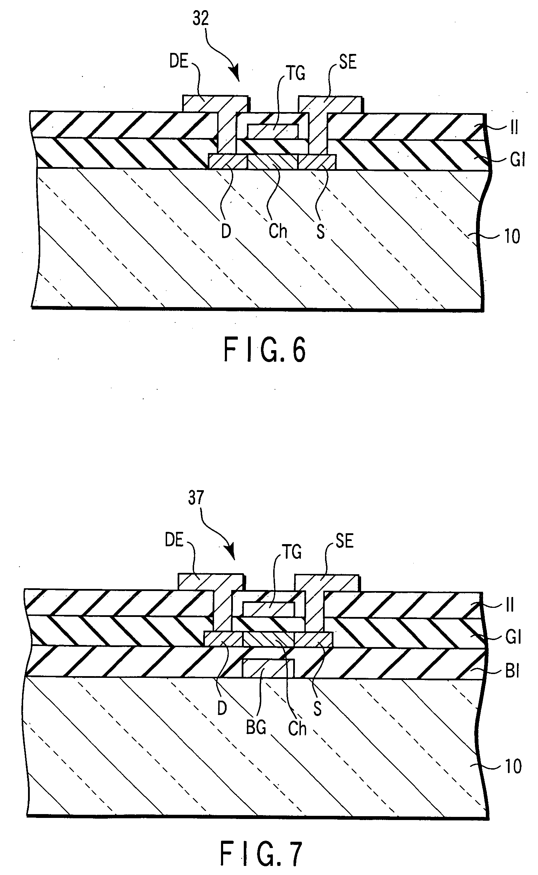

FIG. 6 is a sectional view schematically showing an example of a structure which can be employed in the first switch. FIG. 7 is a sectional view schematically showing an example of a structure which can be employed in the second switch.

The first switch 37 shown in FIG. 6 is a top-gate p-channel thin-film transistor. This thin-film transistor includes a semiconductor layer in which a source S, a drain D, and a channel Ch between them are formed. A gate insulator GI is formed on the channel Ch. A gate TG is formed on the gate insulator GI. The gate TG is covered with an interlayer insulator II. A source electrode SE and drain electrode DE are formed on the interlayer insulator II. The source electrode SE and drain electrode DE are connected to the source S and drain D, respectively, via through holes formed in the gate insulator GI and interlayer insulator II.

The second switch 32 shown in FIG. 7 has the same structure as the first switch 37 shown in FIG. 6 except that an insulating film BI is formed under the channel Ch, and a back gate BG is formed under the insulating film BI. A bias which deepens the threshold value of the second switch 32 is applied to the back gate BG. For example, the voltage between the back gate BG and source S of the second switch 32 is set to about +0.2V to +1.0V.

When the structures shown in FIGS. 6 and 7 are employed in the first switch 37 and second switch 32, respectively, the threshold value of the second switch 32 becomes deeper than that of the first switch 37. In this case as well, the second switch 32 can be set in the non-conductive state earlier than the first switch 37.

FIGS. 6 and 7 show examples of top-gate thin-film transistors. As the first switch 37 and second switch 32, bottom-gate thin-film transistors may be used instead. In this case as well, when the second switch 32 employs the back gate structure, the threshold value of the second switch 32 becomes deeper than that of the first switch 37. The back gate here means a gate which opposes the control terminal via a gate insulator and semiconductor layer.

The techniques described in the first embodiment can be combined with each other. That is, two or more of the methods of changing the threshold value between the first switch 37 and the second switch 32, i.e., the method using the channel length, the method using the number of channels, the method using the impurity dose, and the method using the back gate structure may be combined.

In the first embodiment, to set the second switch 32 in the non-conductive state earlier than the first switch 37, the threshold value is changed between the first switch 37 and the second switch 32. The time lag in switching can also be ensured by another method.

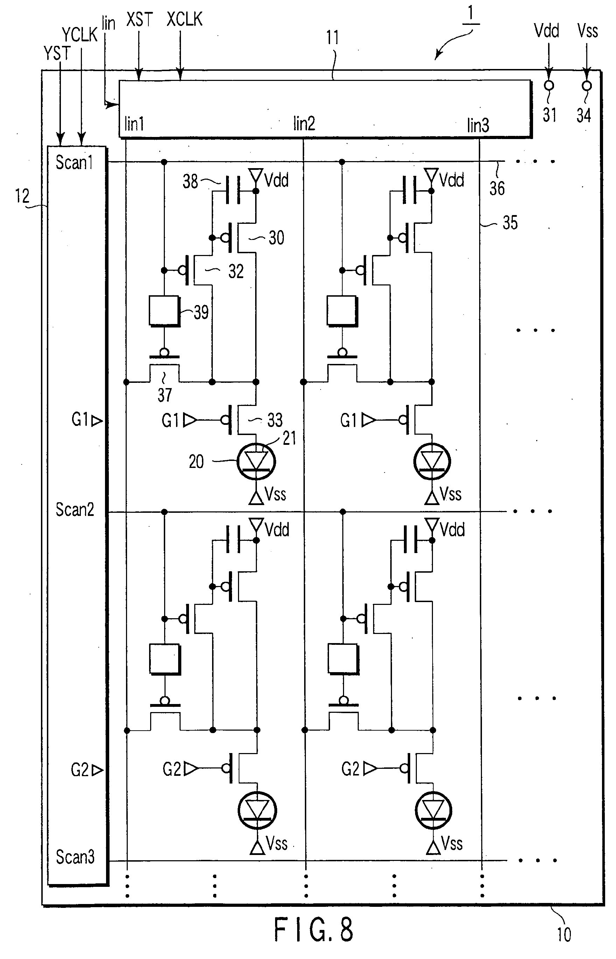

FIG. 8 is a plan view schematically showing an organic EL display according to the second embodiment of the present invention.

An organic EL display 1 has the same structure as the organic EL display 1 shown in FIG. 1 except the following structure. In the organic EL display 1 shown in FIG. 8, a first switch 37 and second switch 32 have the same structure. In addition, in the display 1, the control terminal of the first switch 37 is connected to a scan signal line 36 through a delay element 39. The control terminal of the second switch 32 is directly connected to the scan signal line 36. The organic EL display 1 shown in FIG. 8 can be driven by the same method described in the first embodiment with reference to FIG. 4.

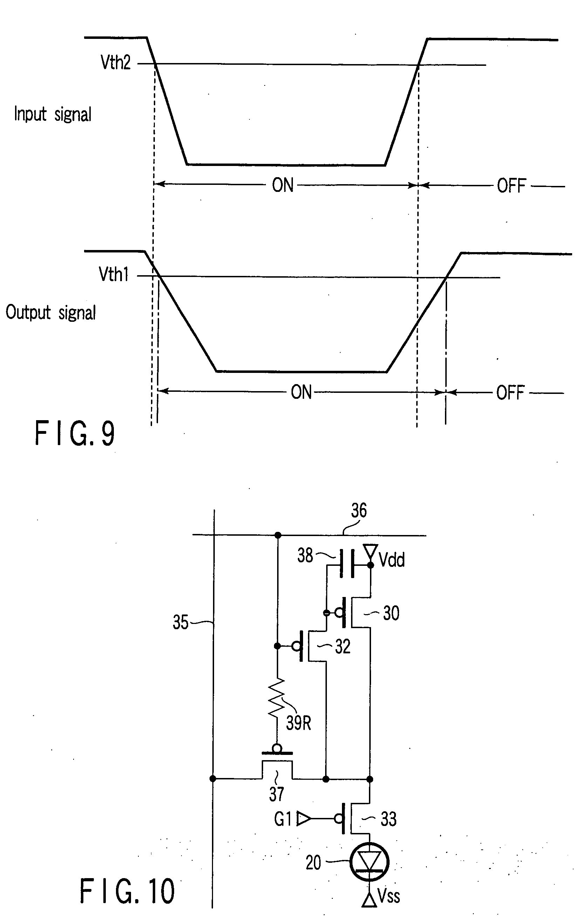

FIG. 9 is a view showing an example of the waveforms of a signal input to the delay element and a signal output from the delay element.

The delay element 39 acts to delay switching of the first switch 37. For example, as shown in FIG. 9, the delay element 39 makes the leading and trailing edges of a scan signal Scan input to it and outputs the scan signal Scan to the control terminal of the first switch 37. On the other hand, the scan signal Scan which is the same as that input to the delay element 39 is supplied to the control terminal of the second switch 32. For this reason, if the threshold value of the first switch 37 almost equals that of the second switch 32, the second switch 32 is set in a non-conductive state earlier than the first switch 37 when an OFF signal is supplied from a scan signal line driver 12 to the scan signal line 36.

As described above, in the organic EL display 1 shown in FIG. 8, the second switch 32 can be set in the non-conductive state earlier than the first switch 37. Hence, according to this embodiment, the organic EL display 1 which suppresses any degradation in grayscale performance or in-plane nonuniformity of luminance can be implemented.

Various elements can be used as the delay element 39.

FIG. 10 is an equivalent circuit diagram showing an example of a pixel circuit which can be employed in the organic EL display shown in FIG. 8.

In this pixel circuit, a resistive element 39R is used as the delay element 39. In this case, as shown in FIG. 9, the signal supplied to the control terminal of the first switch 37 delays from the signal supplied to the control terminal of the second switch 32.

As the resistive element 39R, for example, a polysilicon layer may be used. The polysilicon layer to be used as the resistive element 39R can be formed simultaneously with the polysilicon layers of a drive control element 30 and various kinds of switches.

For the resistive element 39R, for example, an n⁺-type polysilicon layer, p⁺-type polysilicon layer, or i-type polysilicon layer can be used as the polysilicon layer. Of these polysilicon layers, the i-type polysilicon layer has the highest resistivity. For this reason, when the i-type polysilicon layer is used, switching of the first switch 37 can sufficiently be delayed from that of the second switch 32 even when the size of the resistive element 39R is small. For example, the area of the resistive element 39R can be about 400 µm² to 1,000 µm².

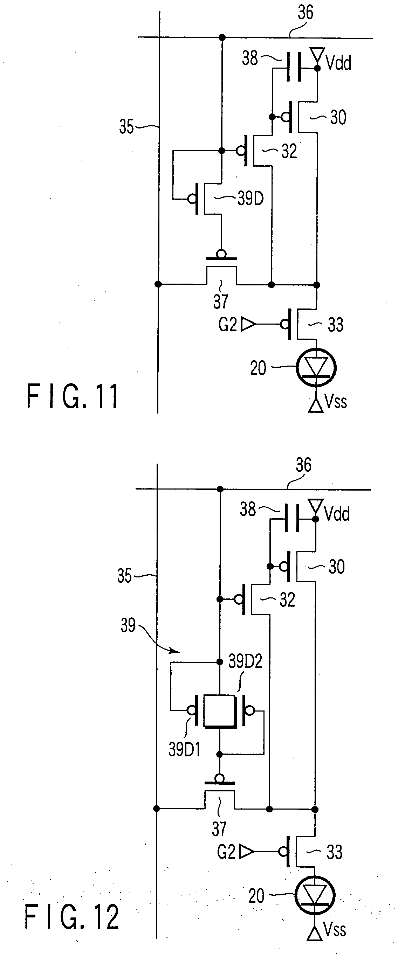

FIG. 11 is an equivalent circuit diagram showing another example of the pixel circuit which can be employed in the organic EL display shown in FIG. 8.

In this pixel circuit, a diode 39D which is connected to supply a forward current from the control terminal of the first switch 37 to the scan signal line 36 is used as the delay element 39. In this pixel circuit, when the scan signal Scan falls, a forward current flows to the diode 39D. For this reason, an ON signal is supplied to the control terminal of the first switch 37 without any delay or with a small delay from the trailing edge of the scan signal Scan. When the scan signal Scan rises, a reverse bias is applied to the diode 39D so that a leakage current flows to the diode 39D. For this reason, an OFF signal is supplied to the control terminal of the first switch 37 with a delay from the leading edge of the scan signal Scan. That is, even in the pixel circuit shown in FIG. 11, the OFF signal supplied to the control terminal of the first switch 37 delays from the OFF signal supplied to the control terminal of the second switch 32.

As the diode 39D, for example, a diode-connected thin-film transistor can be used. In this example, as shown in FIG. 11, a p-channel thin-film transistor is used as the diode 39D, which is connected between the scan signal line 36 and the control terminal of the first switch 37 and whose gate is connected to its drain. The thus connected transistor 39D functions as a diode. When the diode-connected thin-film transistor is used as the diode 39D, it can be formed simultaneously with the drive control element 30 and various kinds of switches.

FIG. 12 is an equivalent circuit diagram showing still another example of the pixel circuit which can be employed in the organic EL display shown in FIG. 8. In this pixel circuit, a first diode 39D1 and second diode 39D2 are used as the delay element 39. The diodes 39D1 and 39D2 are connected in parallel between the control terminal of the first switch 37 and the control terminal of the second switch 32. In addition, the forward direction of the first diode 39D1 is reverse to that of the second diode 39D2.

In this pixel circuit, when the scan signal Scan falls, a forward current flows to the first diode 39D1. More specifically, an ON signal is supplied to the control terminal of the first switch 37 at the trailing edge of the scan signal Scan. When the scan signal Scan rises, a forward current flows to the second diode 39D2. The forward resistance of the second diode 39D2 is set such that an OFF signal is supplied to the control terminal of the first switch 37 with a delay from the leading edge of the scan signal Scan. When the forward resistances of the diodes 39D1 and 39D2 are thus set, the OFF signal supplied to the control terminal of the first switch 37 delays from the OFF signal supplied to the control terminal of the second switch 32.

In the pixel circuit shown in FIG. 12, the delay time of the ON signal to be supplied to the control terminal of the first switch 37 can be adjusted in accordance with the forward resistance of the first diode 39D1. Additionally, in this pixel circuit, the delay time of the OFF signal to be supplied to the control terminal of the first switch 37 can be adjusted in accordance with the forward resistance of the second diode 39D2. That is, the delay time of the OFF signal can be set independently of the delay time of the ON signal. For this reason, when the structure shown in FIG. 12 is employed in the pixel circuit, design at a higher degree of freedom is possible.

As the diodes 39D1 and 39D2, for example, diode-connected thin-film transistors can be used. In this example, as shown in FIG. 12, a p-channel thin-film transistor is used as the first diode 39D1, which is connected between the scan signal line 36 and the control terminal of the first switch 37 and whose gate is connected to its drain. In addition, a p-channel thin-film transistor is used as the second diode 39D2, which is connected between the scan signal line 36 and the control terminal of the first switch 37 and whose gate is connected to its source. The thus connected transistors 39D1 and 39D2 function as diodes whose forward directions are reverse to each other. When the diode-connected thin-film transistors are used as the diodes 39D1 and 39D2, they can be formed simultaneously with the drive control element 30 and various kinds of switches.

The techniques described in the second embodiment can be combined with each other. For example, a structure including the resistive element 39R and the diode 39D, which are connected in series, may be used as the delay element 39. Alternatively, a structure including the resistive element 39R and the diodes 39D1 and 39D2 connected in parallel with the resistive element 39R may be used as the delay element 39.

The above-described techniques of the second and first embodiments can be combined with each other. More specifically, the threshold value may be changed between the first switch 37 and the second switch 32, as described in the first embodiment, and simultaneously, the delay element 39 described in the second embodiment may be arranged in the pixel circuit.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

## Claims

1. An active matrix organic EL display comprising:
a drive control element comprising a first terminal connected to a first power supply terminal, a control terminal to which a video signal is supplied from a video signal input terminal, and a second terminal which outputs a driving current having a magnitude corresponding to a voltage between the control terminal and the first terminal;
an organic EL element connected between the second terminal and a second power supply terminal;
a capacitor which has one electrode connected to the control terminal and can maintain the voltage between the control terminal and the first terminal at a magnitude corresponding to the video signal;
a first switch which executes switching in accordance with a scan signal to set the video signal input terminal and the second terminal in a connected state during a signal write period and set the video signal input terminal and the second terminal in a disconnected state during a light emission period next to the signal write period; and
a second switch which executes switching in accordance with the scan signal to set the control terminal and the second terminal in the connected state during the signal write period and set the control terminal and the second terminal in the disconnected state before the first switch changes to the disconnected state.

2. An active matrix organic EL display comprising:
a drive control element which comprising a first terminal connected to a first power supply terminal, a control terminal, and a second terminal which outputs a driving current having a magnitude corresponding to a voltage between the control terminal and the first terminal;
an organic EL element connected between the second terminal and a second power supply terminal;
a capacitor connected between a constant potential terminal and the control terminal;
a first switch connected between a video signal input terminal and the second terminal; and
a second switch connected between the control terminal and the second terminal,
wherein a control terminal which controls switching of the first switch is connected to a control terminal which controls switching of the second switch, and a threshold value of the first switch is shallower than a threshold value of the second switch.

3. A display according to claim 1 or 2, wherein the first and second switches are thin-film transistors of first conduction type.

4. A display according to claim 3, wherein a channel length of the second switch is longer than a channel length of the first switch.

5. A display according to claim 3, wherein the second switch has a multi-gate structure.

6. A display according to claim 3, wherein a concentration of an impurity of first conduction type in a channel region is higher in the first switch than in the second switch.

7. A display according to claim 3, wherein the drive control element is a thin-film transistor of first conduction type.

8. A display according to claim 1 or 2, wherein an absolute value of a difference between the threshold value of the first switch and the threshold value of the second switch is 0.2V to 1V.

9. An active matrix organic EL display comprising:
a drive control element comprising a first terminal connected to a first power supply terminal, a control terminal, and a second terminal which outputs a driving current having a magnitude corresponding to a voltage between the control terminal and the first terminal;
an organic EL element connected between the second terminal and a second power supply terminal;
a capacitor connected between a constant potential terminal and the control terminal;
a delay element comprising an input terminal connected to a control signal input terminal and an output terminal which outputs a control signal supplied from the control signal input terminal;
a first switch connected between a video signal input terminal and the second terminal; and
a second switch connected between the control terminal and the second terminal,
wherein a control terminal which controls switching of the first switch is connected to the output terminal, and a control terminal which controls switching of the second switch is connected to the control signal input terminal.

10. A display according to claim 9, wherein the delay element is a resistive element.

11. A display according to claim 10, wherein the resistive element is a polysilicon layer containing an impurity.

12. A display according to claim 9, wherein the delay element is a diode connected between the control signal input terminal and the control terminal of the first switch.

13. A display according to claim 9, wherein the delay element comprises first and second diodes connected in parallel between the control signal input terminal and the control terminal of the first switch, and a forward direction of the first diode is reverse to a forward direction of the second diode.

14. An active matrix substrate on which an organic EL element is to be formed, comprising:
a drive control element comprising a first terminal connected to a power supply terminal, a control terminal to which a video signal is supplied from a video signal input terminal, and a second terminal which is connected to the organic EL element and outputs a driving current having a magnitude corresponding to a voltage between the control terminal and the first terminal;
a capacitor which has one electrode connected to the control terminal and can maintain the voltage between the control terminal and the first terminal at a magnitude corresponding to the video signal;
a first switch which executes switching in accordance with a scan signal to set the video signal input terminal and the second terminal in a connected state during a signal write period and set the video signal input terminal and the second terminal in a disconnected state during a light emission period next to the signal write period; and
a second switch which executes switching in accordance with the scan signal to set the control terminal and the second terminal in the connected state during the signal write period and set the control terminal and the second terminal in the disconnected state before the first switch changes to the disconnected state.

15. An active matrix substrate comprising:
a pixel electrode;
a drive control element comprising a first terminal connected to a power supply terminal, a control terminal to which a video signal is supplied from a video signal input terminal, and a second terminal which is connected to the pixel electrode and outputs a driving current having a magnitude corresponding to a voltage between the control terminal and the first terminal;
a capacitor which has one electrode connected to the control terminal and can maintain the voltage between the control terminal and the first terminal at a magnitude corresponding to the video signal;
a first switch which executes switching in accordance with a scan signal to set the video signal input terminal and the second terminal in a connected state during a signal write period and set the video signal input terminal and the second terminal in a disconnected state during a light emission period next to the signal write period; and
a second switch which executes switching in accordance with the scan signal to set the control terminal and the second terminal in the connected state during the signal write period and set the control terminal and the second terminal in the disconnected state before the first switch changes to the disconnected state.
